(19) Europäisches Patentamt
European Patent Office
Office européen des brevets

(11) EP 1 691 410 A2

(12) EUROPEAN PATENT APPLICATION

(43) Date of publication:
**16.08.2006 Bulletin 2006/33**

(21) Application number: **06003024.4**

(22) Date of filing: **15.02.2006**

(51) Int Cl.:
***H01L 21/768*** *(2006.01)* ***H01L 21/311*** *(2006.01)*
***H01L 21/316*** *(2006.01)* ***H01L 21/312*** *(2006.01)*
***G03F 7/09*** *(2006.01)*

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.02.2005 US 652875 P**
**08.02.2006 US 350322 P**

(71) Applicant: **Air Products and Chemicals, Inc.**
**Allentown, PA 18195-1501 (US)**

(72) Inventors:
- **O'Neill, Mark Leonard**
**Allentown**
**PA 18104 (US)**
- **Weigel, Scott Jeffrey**
**Allentown**
**PA 18104 (US)**
- **Rennie, David Barry**
**Bethlehem**
**PA 18018 (US)**
- **Roberts, David Allen**
**Fogelsville**
**PA 18051 (US)**
- **Karwacki, Eugene Joseph, Jr.**
**Orefield**
**PA 18069 (US)**
- **Mac Dougall, James Edward**
**New Tripoli**
**PA 18066 (US)**

(74) Representative: **Kador & Partner**
**Corneliusstrasse 15**
**80469 München (DE)**

(54) **Method for defining a feature on a substrate**

(57) An improved method of forming a feature in a semiconductor substrate is described. The method comprises the steps of forming a porous dielectric layer on a substrate; removing a first portion of the porous dielectric layer to form a first etched region; filling the first etched region with a porous sacrificial light absorbing material having dry etch properties similar to those of the porous dielectric layer; removing a portion of the porous sacrificial light absorbing material and a second portion of the porous dielectric layer to form a second etched region; and removing the remaining portions of the porous sacrificial light absorbing material by employing a process, wherein the porous sacrificial light absorbing material has an etch rate greater than that of the porous dielectric layer in the process.

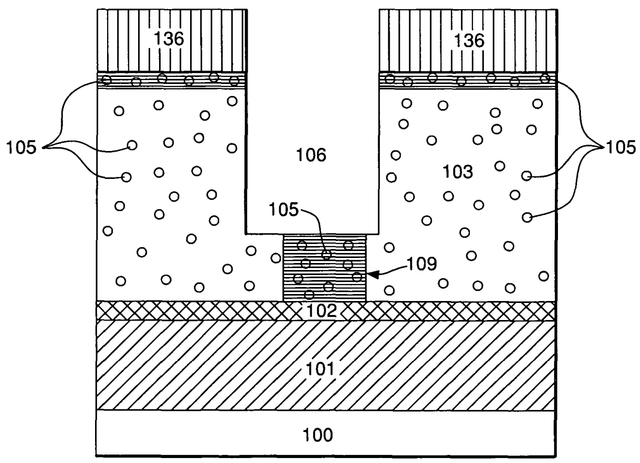


Figure 1F

EP 1 691 410 A2

## Description

CROSS-REFERENCE TO RELATED APPLICATIONS

This application claims the benefit of priority under 35 U.S.C. § 119(e) to earlier filed U.S. patent application Serial No. 60/652,875, filed on February 15, 2005, the disclosure of which is incorporated by reference in its entirety.

BACKGROUND OF THE INVENTION

The present invention relates to a method for making a semiconductor device.

To meet the requirements for faster performance, the characteristic dimensions of features of integrated circuit devices have continued to be decreased. Manufacturing of devices with smaller feature sizes introduces new challenges in many of the processes conventionally used in semiconductor fabrication. The escalating requirements for high-density and performance associated with ultra large-scale integration semiconductor wiring require responsive changes in interconnect technology. Such escalating requirements have been found difficult to satisfy in terms of providing a low RC (resistance capacitance) interconnect pattern, particularly where sub-micron via contacts and trenches have high aspect ratios imposed by miniaturization. Efforts to ameliorate the deleterious effects of increased component densities and decreased interconnect cross-sections include the use of insulating materials with lower dielectric constants than typical oxide insulators ("low k materials"), and the use of conducting materials with higher conductivity than typical aluminum (Al) conductors. Copper is emerging as the leading material for use as the on-chip conductor in typical present-generation interconnects (ICs).

Copper (Cu), however, presents challenges to precise patterning and etching. For example, Cu does not readily form volatile chlorides or fluorides, rendering typical plasma etching based upon chlorine and/or fluorine chemistries impractically slow. Thus, subtractive patterning of Cu, in which a Cu layer is selectively etched away below a patterned layer of photoresist, has been largely replaced by "damascene" or "dual damascene" patterning. The resulting IC structures or features are referred to as damascene or dual damascene structures or features.

Problems can occur in the patterning and the fabrication of features in ICs as a result of reflection of the exposing radiation from the surface (or surfaces) lying below the layer of photoresist. For example, interferences of incident and reflected radiation occurring within the layer of photoresist lead to non-uniform photoresist exposure and imprecise patterning. In addition, exposing radiation can reflect from surface topography or regions of non-uniform reflectivity resulting in exposure of photoresist in regions lying beneath the photomask and for which exposure is not desired. In both cases, variations in the feature critical dimensions ("CDs") can occur, adding to the challenges of precise and reproducible fabrication of IC features.

A common practice to eliminate or reduce fabrication problems resulting from radiation reflection is the use of an anti-reflective coatings. For example, Bottom-Antireflective-Coatings ("BARCs") are commonly applied beneath the photoresist layer, lying on the surface to be patterned. BARC layers may be designed to absorb radiation that penetrates the layer of photoresist and, by this mechanism, reduce or eliminate the deleterious effects of reflections from the underlying surface. In addition, BARC layers may be designed through choice of BARC material and thickness such that, at the wavelength of the exposing radiation, destructive interference occurs between incident and reflected radiation. Both absorptive and destructive interference effects may be used in the same BARC layer.

Damascene patterning may include filling a first etched region (*e.g.*, a via or trench) with a sacrificial light absorbing material ("SLAM") after that region has been formed within a dielectric layer. The SLAM may comprise a dyed spin-on-glass ("SOG"), for example, that has dry etch properties similar to those of the dielectric layer and light absorbing properties that enable the substrate to absorb light during lithography. After the first etched region is filled with the SLAM, a second etched region is formed within the dielectric layer. Most of the SLAM may be removed as that second etched region is formed. Remaining portions of the SLAM are removed by a subsequent wet etch step. Next, a blanket deposition of the Cu or other interconnect material (preceded by the deposition of barrier/adhesion layer(s) if necessary) may be performed. The deposited metal typically fills the patterned features in the insulator and coats the field regions between features. Metal coating on the field region can be removed by chemical-mechanical-planarization ("CMP") or other techniques, exposing the metal-filled features in the insulator for further coating or other processing. Thus, a pattern of interconnects is created in one or more insulating layers without the need for etching a pattern directly into Cu or other metal.

Porous dielectric layers have recently gained in popularity. The use of porous dielectric materials with a SLAM (which includes BARC materials), has given rise to other problems. For example, an issue with using porous dielectric layers relative to dense dielectric materials currently used in the art is that dry etch rates and chemical compatability will depend upon material properties such that the etch rate selectivities for a porous dielectric and the current art SLAM are not properly balanced.

Thus, a need exists in the art for a novel SLAM to enable, among other things, production of damascene and

dual damascene features in porous dielectrics.

BRIEF SUMMARY OF THE INVENTION

A method of forming a feature in a substrate is disclosed herein. The method comprises the steps of forming a porous dielectric layer on a substrate; removing a first portion of the porous dielectric layer to form a first etched region; filling the first etched region with a porous sacrificial light absorbing material having dry etch properties similar to those of the porous dielectric layer; removing a portion of the porous sacrificial light absorbing material and a second portion of the porous dielectric layer to form a second etched region; and removing the remaining portions of the porous sacrificial light absorbing material by employing a process wherein the porous sacrificial light absorbing material has an etch rate greater than that of the porous dielectric layer in the process.

BRIEF DESCRIPTION OF SEVERAL VIEWS OF THE DRAWINGS

FIGS. 1A-1H illustrate cross-sections that reflect structures that may result after certain steps are used to make a semiconductor device that has a dual damascene interconnect, following one embodiment of the present invention;
FIG. 2 provides a flow diagram of an embodiment of the present invention that involves a BARC layer; and
FIG. 3 provides an exemplary experimental set-up for a dry etch removal process for use in accordance with the present invention.

DETAILED DESCRIPTION OF THE INVENTION

A method of forming a semiconductor device is described. In one embodiment of the present invention, the method comprises the following steps. First, a porous dielectric layer is formed on a semiconductor wafer and patterned to define regions to be etched. A first etch region is formed by removing a first portion of the porous dielectric layer. That first etched region is filled with a porous sacrificial light absorbing material that has dry etch properties similar to those of the porous dielectric layer. A layer of photoresist is then deposited and patterned to define a second region to be etched. A second pattern is defined a second region to be etched. The second region is formed by removing part of the porous sacrificial light absorbing material and a second portion of the porous dielectric layer. The resulting article is then exposed to, for example, a wet etch solution to remove the remaining portions of the porous sacrificial light absorbing material.
FIGS. 1A-1H illustrate a preferred embodiment of the method of the present invention. In that embodiment, first conductive layer 101 is optionally formed on substrate 100. Substrate 100 may be any surface, generated when making an integrated circuit, upon which a conductive layer may be formed. Substrate 100 thus may include, for example, active and passive devices that are formed on a silicon wafer such as transistors, capacitors, resistors, diffused junctions, gate electrodes, local interconnects, etc.... Substrate 100 also may include insulating materials that separate such active and passive devices from the conductive layer or layers that are formed on top of them, and may include previously formed conductive layers.
Suitable materials that may be included in substrate 100 include, but are not limited to, semiconductor materials such as gallium arsenide ("GaAs"), silicon, and compositions containing silicon such as crystalline silicon, polysilicon, amorphous silicon, epitaxial silicon, silicon dioxide ("$SiO_2$"), silicon glass, silicon nitride, fused silica, glass, quartz, borosilicate glass, and combinations thereof. Other suitable materials include chromium, molybdenum, and other metals commonly employed in semi-conductor, integrated circuits, flat panel display, and flexible display applications. Substrate 100 may have additional layers such as, for example, silicon, $SiO_2$, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide. Still further layers can also be germanosilicates, aluminosilicates, copper and aluminum, and diffusion barrier materials such as, but not limited to, TiN, Ti(C)N, TaN, Ta(C)N, Ta, W, or WN.
Conductive layer 101 may be made from materials conventionally used to form conductive layers for semiconductor devices. In a preferred embodiment, conductive layer 101 includes copper, and is formed using a conventional copper electroplating process. Although copper is preferred, other conducting materials, which may be used to make a semiconductor device, may be used instead. Conductive layer 101 may be planarized, after it is deposited, using a chemical mechanical polishing ("CMP") step.
After forming conductive layer 101 on substrate 100, barrier layer 102 is typically formed on conductive layer 101. Barrier layer 102 typically serves to prevent an unacceptable amount of copper, or other metal, from diffusing into dielectric layer 103. Barrier layer 102 also acts as an etch stop to prevent subsequent via and trench etch steps from exposing conductive layer 101 to subsequent cleaning steps. Barrier layer 102 preferably is made from a hermetic

dielectric material such as, or example, silicon, $SiO_2$, organosilicate glass (OSG), boron carbonitride, fluorinated silicate glass (FSG), silicon carbide, hydrogenated silicon carbide, silicon nitride, hydrogenated silicon nitride, silicon carbonitride, hydrogenated silicon carbonitride, boronitride, organic-inorganic composite materials, organic and inorganic materials and composites, metal oxides such as aluminum oxide, germanium oxide, and combinations thereof.

A chemical vapor deposition process may be used to form barrier layer 102. Barrier layer 102 should be thick enough to perform its diffusion inhibition and etch stop functions, but not so thick that it adversely impacts the overall dielectric characteristics resulting from the combination of barrier layer 102 and dielectric layer 103. FIG. 1A illustrates a cross-section of the structure that results after conductive layer 101 and barrier layer 102 have been formed on substrate 100.

Referring to Figure 1B, porous dielectric layer 103 is then formed on top of barrier layer 102. In the method of the present invention, porous dielectric layer 103 is formed from the deposition of a film-forming composition comprising a compound or compounds that are capable of forming and maintaining an interconnect network. Examples of the films include, but are not limited to, $SiO_2$, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide, diamond-like carbon, borosilicate glass (Si:O:B:H), or phosphorous doped borosilicate glass (Si:O:B:H:P), and combinations thereof.

In preferred embodiments of the present invention, porous dielectric layer 103 comprises a silica material. The term "silica", as used herein, is a material that has silicon (Si) and oxygen (O) atoms, and possibly additional substituents such as, but not limited to, other elements such as C, H, B, N, P, or halide atoms; alkyl groups; or aryl groups. In alternative embodiments, porous dielectric layer 103 is may contain, for example, other elements such as, but not limited to, Al, Ti, V, In, Sn, Zn, Ga, and combinations thereof. In certain preferred embodiments, dielectric layer 103 may comprise an OSG compound represented by the formula $Si_vO_wC_xH_yF_z$, where v+w+x+y+z = 100 atomic%, v is from 10 to 35 atomic%, w is from 10 to 65 atomic%, x is from 5 to 30 atomic%, y is from 10 to 50 atomic% and z is from 0 to 15 atomic%.

Still referring to Figure 1 B, porous dielectric layer 103 is characterized by the presence of pores 105. In such embodiments, pores 105 are formed when the film-forming composition comprises a silica source and at least one porogen that is capable of being easily, and preferably substantially removed upon exposure to one or more energy sources. A "porogen" is a reagent that is used to generate void volume within the resultant film. Regardless of whether or not the porogen is unchanged throughout the inventive process, the term "porogen" as used herein is intended to encompass pore-forming reagents (or pore-forming substituents) and derivatives thereof, in whatever forms they are found throughout the entire process described herein. Suitable compounds to be used as the porogen include, but are not limited to, hydrocarbon materials, labile organic groups, solvents, decomposable polymers, surfactants, dendrimers, hyper-branched polymers, polyoxyalkylene compounds, compounds comprising C and H, or combinations thereof. In certain embodiments, the porogen comprises a $C_1$ to $C_{13}$ hydrocarbon compound.

In forming pores 105, the as-deposited material from which dielectric layer 103 is made is typically exposed to one or more energy sources to cure the film and/or remove at least a portion of the porogen contained therein if present. Exemplary energy sources may include, but are not limited to, an ionizing radiation source such as $\alpha$-particles, $\beta$-particles, $\gamma$-rays, x-rays, electron beam sources of energy; a nonionizing radiation source such as ultraviolet (10 to 400 nm), visible (400 to 750 nm), infrared (750 to $10^5$ nm), microwave (> $10^6$), and radio-frequency (> $10^6$) wavelengths of energy; or compositions thereof. Still further energy sources include thermal energy and plasma energy. Depending upon the energy source, the exposure step can be conducted under high pressure, atmospheric, or under a vacuum. The environment can be inert *(e.g.,* nitrogen, $CO_2$, noble gases (He, Ar, Ne, Kr, Xe), etc.), oxidizing *(e.g.,* oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), *etc.*). The temperature for the exposure step may range from 100 to 500°C. In certain embodiments, the temperature may be ramped at a rate is from 0.1 to 100 deg °C/min. The total treatment time is preferably from 0.01 min to 12 hours.

In embodiments where pores 105 are formed by photocuring for the selective removal of the porogen and/or perfecting the lattice structure of the film, such process is conducted under the following conditions: the environment can be inert *(e.g.,* nitrogen, $CO_2$, noble gases (He, Ar, Ne, Kr, Xe), etc.), oxidizing *(e.g.,* oxygen, air, dilute oxygen environments, enriched oxygen environments, ozone, nitrous oxide, etc.), or reducing *(e.g.,* dilute or concentrated hydrocarbons, hydrogen, etc.). The temperature is preferably ambient to 500°C. The wavelengths are preferably IR, visible, UV or deep UV (wavelengths < 200nm). The total curing time is preferably 0.01 min to 12 hours.

In embodiments where pores 105 are formed by microwave post-treatment for selective removal of the porogen and/or perfecting the lattice structure of the film, such process is conducted under the following conditions: the environment can be inert *(e.g.,* nitrogen, $CO_2$, noble gases (He, Ar, Ne, Kr, Xe), etc.), oxidizing *(e.g.,* oxygen, air, dilute oxygen environments, enriched oxygen environments, ozone, nitrous oxide, etc.), or reducing *(e.g.,* dilute or concentrated hydrocarbons, hydrogen, etc.). The temperature is preferably ambient to 500°C. The total curing time is preferably from

0.01 min to 12 hours.

In embodiments where pores 105 are formed by electron beam post-treatment for selective removal of pore-formers or specific chemical species from an organosilicate film and/or improvement of film properties, such process is conducted under the following conditions: the environment can be vacuum, inert *(e.g.,* nitrogen, $CO_2$, noble gases (He, Ar, Ne, Kr, Xe), etc.), oxidizing *(e.g.,* oxygen, air, dilute oxygen environments, enriched oxygen environments, ozone, nitrous oxide, etc.), or reducing *(e.g.,* dilute or concentrated hydrocarbons, hydrogen, etc.). The temperature is preferably ambient to 500°C. The electron density and energy can be varied. The total curing time is preferably from 0.001 min to 12 hours, and may be continuous or pulsed. Additional guidance regarding the general use of electron beams is available in publications such as: S. Chattopadhyay et al., Journal of Materials Science, 36 (2001) 4323-4330; G. Kloster et al., Proceedings of IITC, June 3-5, 2002, SF, CA; and U.S. Pat. Nos. 6,207,555 B1, 6,204,201 B1 and 6,132,814 A1.

Porous dielectric layer 103 is typically formed as a film onto at least a portion of substrate 100 (which includes conductive layer 101) from a film-forming composition using a variety of different methods. These methods may be used by themselves or in combination. Some examples of processes that may be used to form the films include the following: thermal chemical vapor deposition, plasma enhanced chemical vapor deposition ("PECVD"), high density PECVD, photon assisted CVD, plasma-photon assisted ("PPECVD"), atomic layer deposition (ALD), cryogenic chemical vapor deposition, chemical assisted vapor deposition, hot-filament chemical vapor deposition, CVD of a liquid polymer precursor, deposition from supercritical fluids, or transport polymerization ("TP"). U. S. Pat. Nos. 6,171,945, 6,054,206, 6,054,379, 6,159,871 and WO 99/41423 provide some exemplary CVD methods that may be used to form the film. Besides chemical vapor deposition processes, other processes that can be used to apply porous dielectric layer 103 such as, for example, non-contact deposition methods. Non-contact deposition methods typically allow films to be formed without the need of contact masks or shutters. Non-contact deposition methods include, for example, dipping, rolling, brushing, spraying, extrusion, spin-on deposition, air-knife, printing, and combinations thereof. Further exemplary deposition methods include oscillating non-contact induced spreading forces, gravity-induced spreading forces, wetting-induced spreading forces, slot extrusion, and combinations thereof.

In one particular embodiment, porous dielectric layer 103 is deposited using a spin-on deposition method. In brief, the film-forming composition is dispensed onto a substrate and the solvent contained therein is evaporated to form the coated substrate. Further, centrifugal force is used to ensure that the composition is uniformly deposited onto the substrate. Another benefit is that the composition efficiently fills any gaps that may be present.

In embodiments where porous dielectric layer 103 is deposited using a spin-on deposition method, the film is typically formed from a composition that comprises, inter *alia,* at least one silica source, optionally a porogen, optionally a catalyst, and water. In certain embodiments, the composition may further optionally comprise a solvent. In brief, dispensing the composition onto a substrate and evaporating the solvent and water can form the film. Any remaining solvent, water, and porogen if present are generally removed by exposing the coated substrate to one or more energy sources and for a time sufficient to produce the low dielectric film. Examples of spin-on deposited materials and films and methods for making same are found in U. S. Published Applications 2004/0048960 and 2003/0224156, which are incorporated herein by reference in their entirety and assigned to the assignee of the present application.

The following silica sources are suitable for use in the present invention in either a spin-on deposition process or a CVD process. As such, at least one of the following silica sources typically form the composition that will be deposited to form porous dielectric layer 103, for example, along with optionally a porogen, optionally a solvent, and optionally water. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula $R_aSi(OR^1)_{4-a}$, when "a" is 2, the two R groups need not be identical to each other or to $R^1$. In addition, in the following formulas, the term "monovalent organic group" relates to an organic group bonded to an element of interest, such as Si or O, through a single C bond, *i.e.*, Si-C or O-C. Examples of monovalent organic groups include an alkyl group, an aryl group, an unsaturated alkyl group, and/or an unsaturated alkyl group substituted with alkoxy, ester, acid, carbonyl, or alkyl carbonyl functionality. The alkyl group may be a linear, branched, or cyclic alkyl group having from 1 to 5 carbon atoms such as, for example, a methyl, ethyl, propyl, butyl, or pentyl group. Examples of aryl groups suitable as the monovalent organic group include phenyl, methylphenyl, ethylphenyl and fluorophenyl. In certain embodiments, one or more hydrogens within the alkyl group may be substituted with an additional atom such as a halide atom (*i.e.*, fluorine), or an oxygen atom to give a carbonyl or ether functionality.

In certain preferred embodiments, the silica source may be represented by the following formula: $R_aSi(OR^1)_{4-a}$, wherein R independently represents a hydrogen atom, a fluorine atom, or a monovalent organic group; $R^1$ independently represents a monovalent organic group; and a is an integer ranging from 1 to 2. Specific examples of the compounds represented by $R_aSi(OR^1)_{4-a}$ include: methyltrimethoxysilane, methyltriethoxysilane, methyltri-n-propoxysilane, methyltri-iso- propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, n-propyltrimethoxysilane, n-propyltriethoxysilane, n-propyltri-n- propoxysilane, n-propyltri-iso-propoxysilane, n-propyltin-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane; sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriphenoxysilane, n-pentyltrimethoxysilane, n-pentyltriethoxysilane, n-pentyltri-n-propoxysilane, n-pentyltriisopropoxysilane, n-pentyltri-n-butoxysilane, n-pentyltri-sec-butoxysilane, n-pentyltri-tert-butoxysilane, n-pentyltriphenoxysilane; sec-pentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyltri-tert-butoxysilane, sec-pentyltriphenoxysilane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriphenoxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriphenoxysilane, neo-pentyltrimethoxysilane, neo-pentyltriethoxysilane, neo-pentyltri-n-propoxysilane, neo-pentyltriisopropoxysilane, neo-pentyltri-n-butoxysilane, neo-pentyltri-sec-butoxysilane, neo-pentyltri-neo-butoxysilane, neo-pentyltriphenoxysilane phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, δ-trifluoropropyltrimethoxysilane, δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldimethoxysilane, di-n-propyldi-n-propoxysilane, di-n-propyldiisopropoxysilane, di-n-propyldi-n-butoxysilane, di-n-propyldi-sec-butoxysilane, din-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n- butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylneopentyldiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethoxysilane, isopropyldiethoxysilane, n-butyldiethoxysilane, sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, allyltrimethoxysilane, allyltriethoxysilane, vinyltrimethoxsilane, vinyltriethoxysilane, (3-acryloxypropyl)trimethoxysilane, allyltrimethoxysilane, allyltriethoxysilane, vinyltrimethoxsilane, vinyltriethoxysilane, and (3-acryloxypropyl)trimethoxysilane. Of the above compounds, the preferred compounds are methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, and diethyldiethoxysilane.

The silica source may also be a compound having the formula $Si(OR^2)_4$ wherein $R^2$ independently represents a monovalent organic group. Specific examples of the compounds represented by $Si(OR^2)_4$ include tetramethoxysilane, tetraethoxysilane, tetra-n-propoxysilane, tetraisopropoxysilane, tetra-n-butoxysilane, tetra-sec-butoxysilane, tetra- tert-butoxysilane, tetraacetoxysilane, and tetraphenoxysilane. Of the above, certain preferred compounds may include tetramethoxysilane, tetraethoxysilane, tetra-n-propoxysilane, tetraisopropoxysilane, or tetraphenoxysilane.

The silica source may also be a compound having the formula $R^3_b(R^4O)_{3-b}Si-(R^7)-Si(OR^5)_{3-c}R^6_c$, wherein $R^3$

and $R^6$ are independently a hydrogen atom, a fluorine atom, or a monovalent organic group; $R^4$ and $R^5$ are independently a monovalent organic group; b and c may be the same or different and each is a number ranging from 0 to 2; $R^7$ is an oxygen atom, a phenylene group, a biphenyl, a naphthalene group, or a group represented by $-(CH_2)_n-$, wherein n is an integer ranging from 1 to 6; or combinations thereof. Specific examples of these compounds wherein $R^7$ is an oxygen atom include: hexamethoxydisiloxane, hexaethoxydisiloxane, hexaphenoxydisiloxane, 1,1,1,3,3-pentamethoxy-3- methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane. Of those, preferred compounds are hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane; 1,3-diethoxy-1,1,3,3-tetraphenyldisiloxane. Specific examples of these compounds wherein $R^7$ is a group represented by $-(CH_2)_n-$include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl) methane, bis(methoxydimethylsilyl)methane, bis(ethoxydimethylsilyl)methane, bis(methoxydiphenylsilyl)methane, bis (ethoxydiphenylsilyl)methane, 1,2-bis(trimethoxysilyl)ethane, 1,2-bis(triethoxysilyl)ethane, 1,2-bis(triphenoxysilyl) ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl)ethane, 1,2-bis(ethoxydimethylsilyl)ethane, 1,2-bis (methoxydiphenylsilyl)ethane, 1,2-bis(ethoxydiphenylsilyl)ethane, 1,3-bis(trimethoxysilyl)propane, 1,3-bis(triethoxysilyl) propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane, and 1,3-bis(ethoxydiphenylsilyl) propane. Of those, preferred compounds are bis(trimethoxysilyl)methane, bis(triethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane and bis(ethoxydiphenylsilyl)methane.

In certain preferred embodiments of the present invention, $R^1$ of the formula $R_aSi(OR^1)_{4-a}$; $R^2$ of the formula $Si(OR^2)_4$; and $R^4$ and/or $R^5$ of the formula $R^3_b(R^4O)_{3-b}Si-(R^7)-Si(OR^5)_{3-c}R^6_c$ can each independently be a monovalent organic group of the formula:

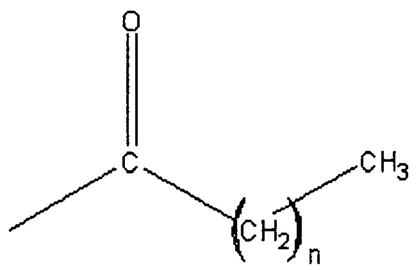

wherein n is an integer from 0 to 4. Specific examples of these compounds include: tetraacetoxysilane, methyltriacetoxysilane, ethyltriacetoxysilane, n-propyltriacetoxysilane, isopropyltriacetoxysilane, n-butyltriacetoxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetoxysilane, diphenyldiacetoxysilane, triacetoxysilane. Of these compounds, tetraacetoxysilane and methyltriacetoxysilane are preferred.

Other examples of the silica source may include a fluorinated silane or fluorinated siloxane such as those provided in U. S. Pat. No. 6,258,407.

Another example of the silica source may include compounds that produce a Si-H bond upon elimination.

In other embodiments of the present invention, the silica source may preferably have an at least one carboxylic acid ester bonded to the Si atom. Examples of these silica sources include tetraacetoxysilane, methyltriacetoxysilane, ethyltriacetoxysilane, and phenyltriacetoxysilane. In addition to the at least one silica source wherein the silica source has at least one Si atom having a carboxylate group attached thereto, the composition may further comprise additional

silica sources that may not necessarily have the carboxylate attached to the Si atom.

The silica source may also be a linear, cyclic, or branched siloxane, a linear, cyclic, or branched carbosiliane, a linear, cyclic, or branched silazane, or mixtures thereof.

In embodiments of the present invention wherein a CVD process is used to deposit, for example, dielectric layer 103, the layer is deposited using gaseous reagents. Although the phrase "gaseous reagents" is sometimes used herein to describe the reagents, the phrase is intended to encompass reagents delivered directly as a gas to the reactor, delivered as a vaporized liquid, a sublimed solid and/or transported by an inert carrier gas into the reactor. In preferred embodiments of the present invention, the material is formed through a PECVD process. In such process, gaseous reagents typically flow into a reaction chamber such as a vacuum chamber and plasma energy energizes the gaseous reagents thereby forming a film on at least a portion of the substrate. In these embodiments, the film can be formed by the co-deposition, or alternatively the sequential deposition, of a gaseous mixture comprising at least one silica-containing precursor gas and at least one plasma-polymerizable organic precursor or porogen gas. In certain embodiments, the plasma energy applied may range from 0.02 to 7 watts/$cm^2$, more preferably 0.3 to 3 watts/$cm^2$. Flow rates for each of the gaseous reagents may range from 10 to 5000 sccm. Pressure values in the vacuum chamber during deposition for a PECVD process of the present invention may range from 0.01 to 600 torr, more preferably 1 to 10 torr. In certain embodiments, the deposition is conducted at a temperature ranging from 100 to 425°C, or from 200 to 425°, or from 200 to 300°. It is understood however that process parameters such as plasma energy, flow rate, pressure, and temperature may vary depending upon numerous factors such as the surface area of the substrate, the precursors used, the equipment used in the PECVD process, etc.

In one embodiment of the CVD process wherein porous dielectric layer 103 consists essentially of Si, C, O, H, and F, porous dielectric layer 103 is formed by providing substrate 100 within a vacuum chamber; introducing into the vacuum chamber gaseous reagents that comprises at least one silica-containing precursor gas selected from the group consisting of an organosilane and an organosiloxane, optionally a fluorine-providing precursor gas, and at least one porogen; and applying energy to the gaseous reagents in the chamber to induce reaction of the gaseous reagents and to form the film on the substrate. Examples of suitable porogen precursors and other silicon-containing precursors are found in U. S. Pat. Nos. 6,726,770, 6,583,048, and 6,846,515, which are incorporated herein by reference in their entirety and assigned to the assignee of the present application. Other suitable porogen precursors are found in U.S. patent publication No. 2002/0180051, and U.S. Patent Nos. 6, 441,491 and 6,437,443, which are incorporated herein by reference in their entirety.

Silica-containing precursors such as organosilanes and organosiloxanes are preferred in the chemical vapor deposition. Suitable organosilanes and organosiloxanes include, *e.g.:* (a) alkylsilanes represented by the formula $R^{11}{}_nSiR^{12}{}_{4-n}$, where n is an integer from 1 to 3; $R^{11}$ and $R^{12}$ are independently at least one branched or straight chain $C_1$ to $C_8$ alkyl group *(e.g.,* methyl, ethyl), a $C_3$ to $C_8$ substituted or unsubstituted cycloalkyl group *(e.g.,* cyclobutyl, cyclohexyl), a $C_3$ to $C_{10}$ partially unsaturated alkyl group *(e.g.,* propenyl, butadienyl), a $C_6$ to $C_{12}$ substituted or unsubstituted aromatic *(e.g.,* phenyl, tolyl), a corresponding linear, branched, cyclic, partially unsaturated alkyl, or aromatic containing alkoxy group *(e.g.,* methoxy, ethoxy, phenoxy), and $R^2$ is alternatively hydride *(e.g.,* methylsilane, dimethylsilane, trimethylsilane, tetramethylsilane, phenylsilane, methylphenylsilane, cyclohexylsilane, tert-butylsilane, ethylsilane, diethylsilane, tetraethoxysilane, dimethyldiethoxysilane, dimethyldimethoxysilane, dimethylethoxysilane, methyldiethoxysilane, triethoxysilane, trimethylphenoxysilane and phenoxysilane); (b) a linear organosiloxane represented by the formula $R^{11}(R^{12}{}_2SiO)_nSiR^{12}{}_3$ where n is an integer from 1 to 10, or cyclic organosiloxane represented by the formula $(R^1R^2SiO)_n$ where n is an integer from 2 to 10 and $R^{11}$ and $R^{12}$ are as defined above (e.g., 1,3,5,7-tetramethylcyclotetrasiloxane, octamethylcyclotetrasiloxane, hexamethylcyclotrisiloxane, hexamethyldisiloxane, 1,1,2,2-tetramethyldisiloxane, and octamethyltrisiloxane); and (c) a linear organosilane oligomer represented by the formula $R^{12}(SiR^{11}R^{12})_nR^{12}$ where n is an integer from 2 to 10, or cyclic organosilane represented by the formula $(SiR^1R^2)_n$, where n is an integer from 3 to 10, and $R^{11}$ and $R^{12}$ are as defined above *(e.g.,* 1,2-dimethyldisilane, 1,1,2,2-tetramethyldisilane, 1,2-dimethyl-1,1,2,2-dimethoxydisilane, hexamethyldisilane, octamethyltrisilane, 1,2,3,4,5,6-hexaphenylhexasilane, 1,2-dimethyl-1,2-diphenyldisilane and 1,2-diphenyldisilane). In certain embodiments, the organosilane/organosiloxane is a cyclic alkylsilane, a cyclic alkoxysilane or contains at least one alkoxy or alkyl bridge between a pair of Si atoms, such as 1,2-disilanoethane, 1,3-disilanopropane, dimethylsilacyclobutane, 1,2-bis(trimethylsiloxy)cyclobutene, 1,1-dimethyl-1-sila-2,6-dioxacyclohexane, 1,1-dimethyl-1-sila-2-oxacyclohexane, 1,2-bis(trimethylsiloxy)ethane, 1,4-bis(dimethylsilyl)benzene or 1,3-(dimethylsilyl)cyclobutane. In certain embodiments, the organosilane/organosiloxane contains a reactive side group selected from the group consisting of an epoxide, a carboxylate, an alkyne, a diene, phenyl ethynyl, a strained cyclic group and a $C_4$ to $C_{10}$ group which can sterically hinder or strain the organosilane/organosiloxane, such as trimethylsilylacetylene, 1-(trimethylsilyl)-1,3-butadiene, trimethylsilylcyclopentadiene, trimethylsilylacetate and di-tert-butoxydiacetoxysilane.

The silica-containing precursors may also be a linear, cyclic, or branched siloxane, a linear, cyclic, or branched carbosiliane, a linear, cyclic, or branched silazane, or mixtures thereof.

In other preferred embodiments of the present invention, the composition further comprises a fluorine-providing

precursor gas. Preferred fluorine-providing precursor gas for a CVD-deposited film lacks any F-C bonds (*i.e.*, fluorine bonded to carbon) that could end up in the film. Exemplary fluorine-providing gases include, *e.g.,* $SiF_4$, $NF_3$, $F_2$, HF, $SF_6$, $ClF_3$, $BF_3$, $BrF_3$, $SF_4$, $NF_2Cl$, $FSiH_3$, $F_2SiH_2$, $F_3SiH$, organofluorosilanes and mixtures thereof. Additional preferred fluorine-providing gases include the above mentioned alkylsilanes, alkoxysilanes, linear and cyclic organosiloxanes, linear and cyclic organosilane oligomers, cyclic or bridged organosilanes, and organosilanes with reactive side groups, provided a fluorine atom is substituted for at least one of the silicon substituents, such that there is at least one Si-F bond. More specifically, suitable fluorine-providing gases include, *e.g.,* fluorotrimethylsilane, difluorodimethylsilane, methyltrifluorosilane, flurotriethoxysilane, 1,2-difluoro-1,1,2,2,-tetramethyldisilane, or difluorodimethoxysilane.

After forming porous dielectric layer 103, a photoresist layer 130 can be patterned on top of it to define, for example, a via formation region for receiving a subsequently formed conductive layer that will contact conductive layer 101. Photoresist layer 130 may be patterned using conventional photolithographic techniques, such as masking the layer of photoresist, exposing the masked layer to light, then developing the photoresist layer. The resulting structure is shown in FIG. 1 B. Although the embodiment herein described involves the use of a photoresist layer, one skilled in the art will appreciate that other patterning techniques can be used, thus rendering the photoresist layer optional. Other patterning techniques available to device manufacturers include, for example, optical lithography, which uses visible or ultraviolet light as the exposure media, x-ray lithography, electron lithography, and printing.

After photoresist layer 130 is patterned, via 107 is etched through porous dielectric layer 103 down to barrier layer 102, barrier layer 102, which acts as an etch stop. Conventional process steps for etching through a dielectric layer may be used to etch the via, *e.g.,* a conventional anisotropic dry etch process. An isotropic or anisotropic forming gas ash may then be applied at an appropriate temperature and pressure to remove the photoresist. A via clean step may follow to produce the structure shown in FIG. 1C.

After via 107 is formed through porous dielectric layer 103, via 107 is filled with a sacrificial light absorbing material that will form a porous sacrificial light absorbing material 104 generating the structure shown in FIG. 1 D. Preferably, porous sacrificial light absorbing material 104 is antireflective. In preferred embodiments, porous sacrificial light absorbing material 104 has dry etch properties similar to those of porous dielectric layer 103, but may be wet etched at a rate that is significantly faster than the rate at which porous dielectric layer 103 may be wet etched. Such dry etch properties should enable removal of most of porous sacrificial light absorbing material 104 at the same time the dielectric layer is etched to form the trench. The high selectivity of porous sacrificial light absorbing material 104 to the wet etch enables removal of that material from the surface of the device, as well as from inside via 107, without causing a significant amount of porous dielectric layer 103 to be removed at the same time.

In preferred embodiments of the present invention, the sacrificial light absorbing material employed to form porous sacrificial light absorbing material 104 comprises any of the above materials that are suitable for use in forming porous dielectric layer 103, including the above-identified porogens. In more preferred embodiments of the present invention, the compositions of porous sacrificial light absorbing material 104 and porous dielectric layer 103 are similar. For example, when an organosilicate-based dielectric is employed to form porous dielectric layer 103, an organosilicate based sacrificial light absorbing material is employed to form porous sacrificial light absorbing material 104.

The sacrificial light absorbing material employed to form porous sacrificial light absorbing material 104 can be deposited in the same manner as described above for porous dielectric layer 103. In some embodiments of the present invention, porous sacrificial light absorbing material 104 is deposited by a spin-on process that deposits a coating between about 500 and about 3,000 angstroms of the material onto the surface of the article. Although only a thin layer will remain on the surface of the device, such a spin coating process should cause the sacrificial light absorbing composition to completely fill via 107. In addition, the porogen-containing sacrificial light absorbing composition should uniformly fill via 107. Such a uniform fill characteristic minimizes void formation, which could jeopardize the integrity of the filling and/or may expose the underlying layer to the etch chemistry used to form the trench for an undesirable extended period of time.

In preferred embodiments, porous sacrificial light absorbing material 104 is light absorbing at wavelengths of 250 nm or below (preferably 248 nm and below), 193 nm or below, extreme UV or below, and 157nm and below. In some applications, it may be preferred that porous sacrificial light absorbing material 104 is light absorbing at wavelengths of 436 and 365 nm (G-I line).

In preferred embodiments, porous sacrificial light absorbing material 104 comprises one or more of the following light-absorbing additives: dyes, saturated or unsaturated organic constituents, photoactive compounds (*e.g.*, photoacid generators (PAG), photobase generators (PAB), and/or photosensitizers), and/or other additives. The term "photoactive compound", as used herein, describes a compound that interacts, absorbs, and/or is affected by exposure to an ionizing radiation source. Suitable PAGs include, but are not limited to, halogenated triazines, onium salts, sulfonated esters, diaryliodonium salts, triazines, iodonium salts, sulfonium salts, diazomethanes, and/or halogenated sulfonyloxy dicarboximides. One particular example of a PAG is an onium salt having weakly nucleophilic anions. Examples of such anions are the halogen complex anions of divalent to heptavalent metals or non-metals, for example, antimony, tin, iron, bismuth, aluminum, gallium, indium, titanium, zirconium, scandium, chromium, hafnium, copper, boron, phosphorus and arsenic. Examples of suitable onium salts include, but are not limited to: diaryl-diazonium salts and onium salts of group

VA and B, IIA and B and I of the Periodic Table, for example, halonium salts, quaternary ammonium, phosphonium and arsonium salts, aromatic sulfonium salts and sulfoxonium salts or selenium salts. Examples of suitable onium salts are disclosed in U.S. Pat. Nos. 4,442,197; 4,603,101; and 4,624,912, all incorporated herein by reference. Particular examples of an onium salt include triphenylsulfonium perfluorobutane sulfonate or nanoflate $[Ph_3S]^+[C_4F_9SO_3]^-$, bis (4-*tert*-butylphenyl) iodonium trifluoromethane sulfonate or triflate, or diphenyliodonium-9,10-dimethoxyanthracene-2-sulfonate. In other embodiments, the PAG is an sulfonated ester. The sulfonated esters useful as photoacid generators in the film-forming composition include sulfonyloxy ketones. Suitable sulfonated esters include, but are not limited to: benzoin tosylate, t-butylphenyl alpha-(p-toluenesulfonyloxy)-acetate, and t-butyl alpha-(p-toluenesulfonyloxy)acetate. Such sulfonated esters are disclosed in the Journal of Photopolymer Science and Technology, vol. 4, No. 3,337-340 (1991), incorporated herein by reference. In other embodiments, the PAG is a nonionic compound. Examples of suitable nonionic PAGs include, but are not limited to: N-Hydroxyphtalimide triflate, 2-(4-Methoxystyryl)-4,6-bis(trichloromethyl)-1,3,5-triazine, and N-hydroxy-5-norbornene-2,3-dicarboximide nanoflate. Some examples of suitable PBGs include, but are not limited to, 2-nitrobenzyl cyclohexanecarbamate and triphenylsulfonium hydroxide. Examples of photosensitizers that suitable for use herein are disclosed in U.S. Pat. Nos. 4,442,197, 4,250,053, 4,371,605, and 4,491,628 which are incorporated herein by reference. Particular examples of photosensitizers that may be used includes isopropyl-9H-thioxanthen-9-one (ITX), anthracene carbonitrile, anthracene methanol, the disodium salt of anthroquinonoe disulfonic acid, pyrene, and perylene. Other examples of light absorbing additives can be found in for example, U.S. Patent No. 6,965,097 and U.S. Patent No. 6,969,753, which are incorporated herein by reference.

In certain embodiments of the present invention, either porous dielectric layer 103 or porous sacrificial light absorbing material 104 may be also subjected to a chemical treatment to enhance the properties of the final material. Chemical treatment of the film may include, for example, the use of fluorinating (HF, $SIF_4$, $NF_3$, $F_2$, $COF_2$, $CO_2F_2$, etc.), oxidizing ($H_2O_2$, $O_3$, etc.), chemical drying, methylating, or other chemical treatments. Chemicals used in such treatments can be in solid, liquid, gaseous and/or supercritical fluid states. In certain embodiments, supercritical fluid treatment may be used to treat the film. The fluid can be carbon dioxide, water, nitrous oxide, ethylene, $SF_6$, and/or other types of chemicals. Other chemicals can be added to the supercritical fluid to enhance the process. The chemicals can be inert (*e.g.*, nitrogen, $CO_2$, noble gases (He, Ar, Ne, Kr, Xe), etc.), oxidizing (*e.g.*, oxygen, ozone, nitrous oxide, etc.), or reducing *(e.g.,* dilute or concentrated hydrocarbons, hydrogen, etc.). The temperature is preferably ambient to 500°C. The chemicals can also include larger chemical species such as surfactants. The total exposure time is preferably from 0.01 min to 12 hours.

In embodiments wherein either or both of porous dielectric layer 103 and porous sacrificial light absorbing material 104 is (are) subjected to a plasma exposure or treatment, such exposure is conducted under the following conditions: the environment can be inert (nitrogen, $CO_2$, noble gases (He, Ar, Ne, Kr, Xe), etc.), oxidizing *(e.g.,* oxygen, air, dilute oxygen environments, enriched oxygen environments, ozone, nitrous oxide, *etc.),* or reducing *(e.g.,* dilute or concentrated hydrogen, hydrocarbons (saturated, unsaturated, linear or branched, aromatics), *etc*.). The plasma power is preferably 0-5000 W. The temperature preferably ranges from ambient to 500°C. The pressure preferably ranges from 10 mtorr to atmospheric pressure. The total treatment time is preferably 0.01 min to 12 hours.

After filling via 107 with porous sacrificial light absorbing material 104, photoresist layer 136 can be applied on top of porous sacrificial light absorbing material 104, then patterned to define a trench formation region. The resulting structure is shown in FIG. 1E. Following that photoresist patterning step, trench 106 is etched into porous dielectric layer 103 to form the structure shown in FIG. 1 F.

In preferred embodiments of the present invention, porous dielectric layer 103 and porous sacrificial light absorbing material 104 are etched to form the structure shown in FIG. *1F* by dry methods *(e.g.,* reactive ion etching, plasma etching, etc.). The etching process is applied for a time sufficient to form a trench having the desired depth. The etch chemistry chosen to etch trench 106 preferably should remove porous sacrificial light absorbing material 104 at about the same rate that it removes porous dielectric layer 103, or perhaps at a slightly faster rate. Trench 106 may be etched using the same equipment and etch chemistry that had been used previously to etch via 107. The presence of portion 109 of porous sacrificial light absorbing material 104, which remains at the bottom of via 107 after the trench etch step, also helps barrier layer 102 to protect conductive layer 101 during the trench etch process.

In certain embodiments of the present invention, the removal is preferably conducted using a plasma reactive ion etch process. In such process, one or more reactive gases are exposed to one or more energy sources sufficient to form active species which then react with and remove the materials from the substrate. The reactive gas may be activated by one or more energy sources such as, but not limited to, in situ plasma, remote plasma, remote thermal/catalytic activation, in-situ thermal heating, electron attachment, and photo activation to form reactive species. These sources may be used alone or in combination. Examples of a suitable removal processes and reactive gases include those described in U. S. Published Patent Applications 2005/011483, 2005/0011859, 2004/0129671, and 2004/0011380, which are incorporated herein by reference in its entirety and assigned to the assignee of the present application.

The reactive gases may be a halogen containing gas *(e.g.,* fluorine-containing gas, chlorine-containing gas, bromine-containing gas or combinations thereof), oxygen-containing gases and mixtures thereof. In addition to the

aforementioned gases, an inert diluent or carrier gas may also be added. Examples of fluorine-containing reactive gases include: HF (hydrofluoric acid), $NF_3$ (nitrogen trifluoride), $SF_6$ (sulfur hexafluoride), FNO (nitrosyl fluoride), $C_3F_3N_3$ (cyanuric fluoride), $C_2F_2O_2$ (oxalyl fluoride), perfluorocarbons such as $CF_4$, $C_2F_6$, $C_3F_8$, $C_4F_8$ etc., hydrofluorocarbons such as $CHF_3$ and $C_3F_7H$ etc., oxyfluorocarbons such as $C_4F_8O$ (perfluorotetrahydrofuran) etc., oxygenated hydrofluorocarbons such as $CH_3OCF_3$ (HFE-143a), hypofluorites such as $CF_3$-OF (fluoroxytrifluoromethane (FTM)) and FO-$CF_2$-OF (bis-difluoroxy-difluoromethane (BDM)), etc., fluoroperoxides such as $CF_3$-O-O-$CF_3$ (bis-trifluoro-methyl-peroxide (BTMP)), F-O-O-F etc., fluorotrioxides such as $CF_3$-O-O-O-$CF_3$ etc., fluoroamines such a $CF_5N$ (perfluoromethylamine), fluoronitriles such as $C_2F_3N$ (perfluoroacetonitrile), $C_3F_6N$ (perfluoroproprionitrile), and $CF_3NO$ (trifluoronitrosylmethane), and $COF_2$ (carbonyl fluoride). Examples of inert diluent gases include nitrogen, $CO_2$, helium, neon, argon, krypton, and xenon. The amount of inert diluent gas that may be present within the process gas can range from 0% to 99.9%. Exemplary oxygen-containing gases include, but are limited to, oxygen ($O_2$), ozone ($O_3$), carbon monoxide (CO), carbon dioxide ($CO_2$), nitrogen dioxide ($NO_2$), nitrous oxide ($N_2O$), and mixtures thereof. Reductive etch processes may also be employed wherein compounds such as, for example, hydrogen, ammonia, helium, nitrogen, and mixtures thereof are employed in such processes.

In thermal heating activation, the substrate is heated either by resistive heaters or by intense lamps. The reactive gas is thermally decomposed into reactive radicals and atoms that subsequently volatize at least a portion of the materials. Elevated temperature may also provide the energy source to overcome reaction activation energy barrier and enhance the reaction rates. For thermal activation, the substrate can be heated to at least 100°C, or at least 300°C, or at least 500 °C. The pressure range is generally 10 mTorr to 760 Torr, or 1 Torr to 760 Torr.

For in situ plasma activation, one can generate the plasma with a 13.56 MHz RF power supply, with RF power density at least 0.2 $W/cm^2$, or at least 0.5 $W/cm^2$, or at least 1 $W/cm^2$. One can also operate the in situ plasma at RF frequencies lower than 13.56 MHz to enhance cleaning of grounded chamber walls and/or fixtures contained therein, or higher than 13.56 MHz to enhance plasma properties. The operating pressure is generally in the range of 2.5 mTorr to 100 Torr, or 5 mTorr to 50 Torr, or 10 mTorr to 20 Torr. Optionally, one can also combine thermal and plasma enhancement.

In certain embodiments, a remote activation source, such as, but not limited to, a remote plasma source, a remote thermal activation source, a remote catalytically activated source, or a source which combines thermal and catalytic activation, is used in addition to an in situ plasma to generate the volatile product. In remote plasma cleaning, the process gas is activated to form reactive species outside of the deposition chamber which are introduced into the process chamber to volatize at least a portion of the materials. Either an RF or a microwave source can generate the remote plasma source. In addition, reactions between remote plasma generated reactive species and the substance to be removed can be activated/enhanced by heating the reactor. The reaction between the remote plasma generated reactive species and substance to be removed can be activated and/or enhanced by heating the reactor to a temperature sufficient to dissociate the oxygen and fluorine containing sources contained within the process gas. The specific temperature required to activate the etching process with the substance to be removed depends on the process gas recipe.

Alternatively, the reactive gas molecules can be dissociated by intense ultraviolet (UV) radiation to form reactive radicals and atoms. UV radiation can also assist breaking the strong chemical bonds in the unwanted materials; hence increase the removal rates of the substance to be removed.

In remote thermal activation, the reactive gas first flows through a heated area outside of the process chamber. Here, the gas dissociates by contact with the high temperatures within a vessel outside of the chamber containing the substrate.

Alternative approaches include the use of a catalytic converter to dissociate the reactive gas, or a combination of thermal heating and catalytic cracking to facilitate activation of the hydrogen and fluorine sources within the process gas.

In alternative embodiments, the molecules of the reactive gas can be dissociated by intense exposure to photons to form reactive species. For example ultraviolet, deep ultraviolet and vacuum ultraviolet radiation can assist breaking strong chemical bonds in the substance to be removed as well as dissociating the hydrogen and fluorine sources within the process gas thereby increasing the removal rates of the undesired substance. Other means of activation and enhancement to etching processes described herein can also be employed. For example, one can use photon induced chemical reactions to generate reactive species and enhance the etching reactions.

Other means of activation and enhancement to the etching processes can also be employed. For example, one can use photon induced chemical reactions, either remotely or *in situ*, to generate reactive species and enhance the etching reactions. One can also use catalytic conversion of reactive gases to form reactive species for cleaning the process chambers.

Still referring to FIGS. 1E and 1F, by filling via 107 with a porous sacrificial light absorbing material having dry etch characteristics like those of dielectric layer 103, the trench lithography process effectively applies to a substantially "hole-free" surface, similar to one without vias. By selecting an appropriate silica-containing material and an appropriate light-absorbing compound for porous sacrificial light absorbing material 104, and an appropriate etch chemistry, trench 106 may be etched into porous dielectric layer 103 at approximately the same rate that porous sacrificial light absorbing

material 104 is removed. Because such a process protects the underlying etched feature of porous dielectric layer 103 as trench 106 is etched, it produces superior trench and via profiles.

After trench 106 is etched, the remaining portion of photoresist 136 may be removed. Typically, a low temperature, low pressure ashing step is employed to remove photoresist 136. In other methods, photoresist layer 136 may be removed by any of the above-described methods that are suitable to remove porous dielectric layer 103 and porous sacrificial light absorbing material 104. Removal of photoresist layer 136 generates the structure shown in FIG. 1 G.

Also after trench 106 is etched, the remaining portion 109 of porous sacrificial light absorbing material 104 must be removed. This is preferably accomplished by employing a process that provides a significantly higher removal rate of the porous sacrificial light absorbing material 104 than that of porous dielectric layer 103. In some embodiments of the present invention, remaining portion 109 of porous sacrificial light absorbing material 104 is removed by a dry etch process that removes remaining portion 109 of porous sacrificial light absorbing material 104 at a significantly higher rate than it removes porous dielectric layer 103.

In preferred embodiments of the present invention, wet etch chemicals that may be employed include, for example, solvents and/or stripper formulations. Solvents can be, for example, alcohol solvents, ketone solvents, amide solvents, or ester solvents. In certain embodiments the solvents may be a supercritical fluid such as carbon dioxide, fluorocarbons, sulfur hexafluoride, alkanes, and other suitable multi-component compositions, etc. In certain embodiments, one or more solvents used in the present invention have relatively low boiling points, *i.e.*, below 160°C. These solvents include, but are not limited to, tetrahydrofuran, acetone, 1,4-dioxane, 1,3-dioxolane, ethyl acetate, and methyl ethyl ketone. Other solvents, that can be used in the present invention but have boiling points above 160°C, include dimethylformamide, dimethylacetamide, N-methyl pyrrolidone, ethylene carbonate, propylene carbonate, glycerol and derivatives, naphthalene and substituted versions, acetic acid anyhydride, propionic acid and propionic acid anhydride, dimethyl sulfone, benzophenone, diphenyl sulfone, phenol, m-cresol, dimethyl sulfoxide, diphenyl ether, terphenyl, and the like. Preferred solvents include propylene glycol propyl ether (PGPE), 3-heptanol, 2-methyl-1-pentanol, 5-methyl-2-hexanol, 3-hexanol, 2-heptano, 2-hexanol, 2,3-dimethyl-3-pentanol, propylene glycol methyl ether acetate (PGMEA), ethylene glycol n-butyl ether, propylene glycol n-butyl ether (PGBE), 1-butoxy-2-propanol, 2-methyl-3-pentanol, 2-methoxyethyl acetate, 2-butoxyethanol, 2-ethoxyethyl acetoacetate, 1-pentanol, and propylene glycol methyl ether. Still further exemplary solvents include lactates, pyruvates, and diols. Further exemplary solvents include those solvents listed in EP 1,127,929. The solvents enumerated above may be used alone or in combination of two or more solvents.

The wet removal can be conducted using one or more stripper formulations. These formulations can be solvent-based, aqueous-based, amine-containing, fluoride-containing, buffered or combinations thereof. The selection of the particular formulation depends upon the identity of the porous dielectric and porous sacrificial light absorbing materials to be removed. Examples of suitable stripper formulations include those described in U. S. Issued Pat. Nos. 6,583,104, 6,677,286, 6,627,546, 6,828,289 and U.S. Published Patent Applications 2004/0266637, 2004/0063042, 2003/0130146, and 2003/0148910, which are incorporated herein by reference in its entirety and assigned to the assignee of the present application.

In preferred embodiments, the removal rate of the remaining portion 109, *i.e.*, the porous sacrificial light absorbing material, should be at least five times greater, or at least ten times greater, than that of porous dielectric layer 103. It is understood however, that depending upon the geometry of the feature to be defined, it may be desirable to add additional removal steps wherein the removal of the porous sacrificial light absorbing material relative to the porous dielectric layer 103 may be substantially the same, or alternatively greater than or less than that of the porous dielectric layer 103.

After the wet etch step, the portion of barrier layer 102 that separates via 107 from conductive layer 101 may be removed to expose conductive layer 101, as shown in FIG. 1H. Following the barrier layer removal step, trench 106 and via 107 may then be filled with a second conductive layer (not shown).

In one particular embodiment, the method described herein made be used in defining a feature involving a porous BARC material as the pourous sacrificial light absorbing material. Figure 2 provides an example of one embodiment of the method described herein that involves a porous BARC material, which is also referred to as a "layer." Referring to Figure 2, in first step 201 a first material which can be, for example, porous low-k material, is deposited onto a substrate. In next step 202, the first material is covered with a first patterned photoresist, and a preliminary removal step 203 which can be, for example, a dry etch (*e.g.*, reactive ion etch (RIE)) is performed to remove the uncovered first material. In next step 204, a layer of a second material, such as, for example a porous BARC, is applied, and it fills in the patterned holes in the first or porous low-k material. In certain embodiments wherein the aspect ratio of the feature is high, the second material is selected such that it fills the gaps efficiently. The substrate is then covered with a second patterned photoresist (step 205). Removal step 206, such as, for example, a RIE etch, is performed to remove the unmasked porous BARC material and portions of the porous low-k material. Removal step 207, such as, for example, a wet etch, is then performed to remove the porous BARC material without affecting the interlayer porous dielectric. In this particular embodiment, the final result 208 of the method described herein is a patterned first material with features such as distinct via and trench patterns having a sharp interface. In this connection, the method may eliminate the need,

for example, of an imbedded etch stop layer between the via and trench levels to achieve these particular features.

In removal step 206, the porous BARC and porous low-k materials are removed by the etchant. Removal step 206 can be conducted, for example, in a vacuum chamber using a dry etch process involving a reactive gas. During removal step 206, the removal rate in the first removal step of the porous BARC material should be substantially the same, *i.e.*, less than three times the removal rate or less than two times the removal rate of the porous low-k material. In removal step 206, the porous BARC and the porous low-k material preferably have substantially the same removal or dry etch rates to remove a certain depth of porous low-k material.

Still referring to Figure 2, removal step 207 removes the porous BARC layer without affecting the underlying first material or porous low-k material. In removal step 207, the removal rate of the porous BARC material should be at least five times greater, or at least ten times greater, than that of the porous low-k material. In one particular embodiment, the second removal step is preferably conducted using a wet etch. In this embodiment, the high selectivity of the wet etch chemical for the porous BARC material relative to the porous low-k material allows for the selective removal of the porous BARC material without affecting the porous low-k material. In alternative embodiments, depending upon the geometry of the substrate and the feature to be defined, it may be desirable that the second removal rate of the porous BARC material be at least five times less than, or at least ten times less than the porous low-k material.

In certain preferred embodiments, a spin-on deposited material such as MESOELK™ be used as the BARC material and a PECVD deposited porous low-k material or PDEMS™ may be used as a low-k material for use in developing interconnect structures for microelectronic applications or for other applications requiring complex structures within silica based materials. In the embodiment shown in Figure 2, the porous low-k material may be, for example, a porous organosilicate produced from a composite material deposited from a silica-containing precursor gas diethoxymethylsilane (DEMS) and an organic porogen. In this embodiment, the PECVD material exhibits a porous structure. Similarly, the MESOELK™ material which is produced via spin-on deposition have been shown to have a similar dry etch rate to the PDEMS™ and a wet etch rate, when the etchant is properly tailored, that is significantly higher than PDEMS™. The MESOELK™ material is generally described in U.S. Patent No. 6,818,289 as a film-forming fluid comprising a functionalized alkoxysilane precursor, a catalyst, a porogen, and a solvent. U.S. Patent No. 6,818,289 is incorporated herein by reference in its entirety. Preferably, a light absorbing compound is added to the functionalized alkoxysilane precursor, catalyst, porogen, and solvent.

Not wishing to be bound by particular theory, it is thought that the composition of both PDEMS™ and MESOELK™ results in similar dry etch rates in those two materials. The pores in these two materials, however, have different structures. MESOELK™ has an open-cell porous structure, while PDEMS™ can have a more disconnected pore structure. These differences may result in different removal rates when exposed to a wet etch process. As mentioned above, PDEMS™ and MESOELK™ are only two examples of particular materials that could be used.

In one particular embodiment, the method described herein provides the features having high aspect ratios due to the selection and deposition of the second material. In this embodiment, the second material has a certain surface tension and viscosity that enables it to fill vias with high aspect ratios.

EXAMPLES

In examples 1-3, the thickness and refractive index of each film were measured on an SCI Filmtek 2000 Reflectometer. Dielectric constants were determined using Hg probe technique on low resistivity p-type wafers (< 0.02 ohm-cm). Mechanical properties were determined using MTS Nano Indenter.

In some of the following examples, UV exposure was performed using a Fusion UV model F305 ultraviolet lamp. The films subjected to UV exposure were placed in a 2" diameter quartz glass tube with sealed end caps. In examples involving a vacuum or inert atmospheres, three pump and purge cycles were performed prior to UV exposure to ensure that any oxygen present was removed from the process tube. Exposure times varied between 0 and 30 minutes.

In examples 4-5, the thickness of each film were determined by spectroscopic ellipsometry using a variable angle spectroscopic ellipsometer, Model SE 800 manufactured by Sentech Instruments GmbH, and calculated by SpectraRay software. The film thickness were obtained by simulating the measurement using various models such as Bruggemann in the wavelength range from 400 to 800 nm with mean square error of about 1 or less. For the thickness values, the error between the simulated thickness and actual film thickness values measured by profilometry was generally less than 2%. The dielectric constant of each exemplary films 4-5 was determined according to ASTM Standard D150-98. The capacitance-voltage of each film were obtained at 1 MHz with a Solartron Model SI 1260 Frequency Analyzer and MSI Electronics Model Hg 401 single contact mercury probe. The error in capacitance measurements and mercury electrode area (A) was less than 1%. The substrate (wafer) capacitance ($C_{Si}$), background capacitance ($C_b$) and total capacitance ($C_T$) were measured between +20 and -20 volts and the thin film sample capacitance ($C_s$) was calculated by Equation (1):

$$C_s = C_{Si} (C_T - C_b) / [C_{Si} - (C_T - C_b)] \qquad \text{Equation (1)}$$

The dielectric constant of each film was calculated by Equation (2) wherein d is the film thickness, A is the mercury electrode area, and $\varepsilon_0$ is the dielectric constant in vacuum:

$$\varepsilon = \frac{C_S d}{\varepsilon_0 A} \qquad \text{Equation (2)}$$

The total error of the dielectric constant of the film was expected to be less than 6%.

Examples 1, 2, and 3: PECVD Deposited Films

Exemplary PECVD films were deposited using an Applied Materials Precision-5000 system in a 200 mm DxZ vacuum chamber that was fitted with an Advance Energy 200 rf generator and using an undoped TEOS process kit. The PECVD process involved the following basic steps: initial set-up and stabilization of gas flows deposition, and purge/evacuation of chamber prior to wafer removal. Exemplary films 1 were deposited using the precursor diethoxymethylsilane (DEMS) with carbon dioxide as carrier gas. Exemplary films 2 were deposited using the precursors DEMS and alphaterpinene (ATP) as the porogen along with carbon dioxide as carrier gas. In Exemplary films 3, the as-deposited films containing DEMS and ATP was exposed to UV light at a pressure of less than 1 torr for 10 minutes to at least partially remove the ATP contained therein. The temperature of the film reached approximately 400°C during the exposure.

Example 4: Spin-on Deposited Films with Dielectric constant of approximately 2.2:

Silica sources 22.5g of tetraethylorthosilicate (TEOS) and 22.5 g of methytriethoxysilane (MTES) are mixed together. 100g of propylene glycol propyl ether (PGPE) and 9.7g of Triton X-114 are added to the silica source and mixed thoroughly. In a separate container, 24g of 0.1 M nitric acid ($HNO_3$) and 1g of 2.4 wt% tetramethylammonium hydroxide (TMAH) are combined and mixed thoroughly. While the silica source solution is mixing, the $HNO_3$ / TMAH solution is added. The entire solution is mixed for 1 hour. Typically, the solution is then aged at room temperature for one day before the solution is filtered through a 0.2 micron Teflon filter. The solution is then deposited onto a Si wafer spinning at 500 rpm for 7 seconds followed by accleration to 1800 rpm for 40 seconds. The film prepared via this method is then cured in air at 90°C for 90 seconds, 180°C for 90 seconds, and 400°C for 3 minutes.

Example 5: Spin-on Deposited Films with Dielectric constant of approximately 1.9:

22.5g of tetraethylorthosilicate (TEOS) and 22.5 g of methytriethoxysilane (MTES) are mixed together. 115g of propylene glycol propyl ether (PGPE) and 16.1g of Triton X-114 are added to the silicates and mixed thoroughly. In a separate container, 24g of 0.1 M nitric acid ($HNO_3$) and 1g of 2.4 wt% tetramethylammonium hydroxide (TMAH) are combined and mixed thoroughly. While the silicate solution is mixing, the $HNO_3$ / TMAH solution is added. The entire solution is mixed for 1 hour. Typically, the solution is then aged at room temperature for one day before the solution is filtered through a 0.2 micron Teflon filter. The solution is then deposited onto a Si wafer spinning at 500 rpm for 7 seconds followed by accleration to 1800 rpm for 40 seconds. The film prepared via this method is then cured in air at 90°C for 90 seconds, 180°C for 90 seconds, and 400°C for 3 minutes.

Removal using Plasma Etching:

The following examples were conducted in a commercial production scale Applied Materials P-5000 Mark II reactor. The experiments were conducted in a parallel plate capacitively coupled RF plasma reactor 300 similar to the setup illustrated in Fig. 3. For each experimental run, a substrate 310 was loaded onto the reactor chuck 320. Process gases 330 were fed into the reactor 300 from a top mounted showerhead 340. The chuck was then powered by a 13.56 MHz RF power source 350 to generate the plasma (not shown). The chuck has a helium backside cooling system 360. Volatile species (not shown) are removed from the reaction chamber 300 through a pumping ring 370 by a turbo pump (not shown). Pumping ring 370 creates an axially symmetric pathway to pump out the gases and volatile species contained therein.

The P-5000 reactor operates in a capacitively coupled reactive ion etcher (RIE) mode. A 200 mm wafer is

placed onto the RF powered lower electrode, which has an effective RF "hot" surface area of about 182 $cm^2$. Chemical reagents such as FTM, Ar, $C_4F_6$, and $O_2$ flow through the showerhead into the reaction chamber. RF power at 13.56 MHz is delivered from an RF generator through an automatic matching network. The Applied Materials Mark II reactor uses a clamping ring mechanical chuck and helium backside cooling at 8 Torr for processing 200 mm wafers. The wafer chuck is water cooled at 20°C. Typical helium backside cooling pressure is servo-controlled at about 8 Torr, The-Applied Materials P-5000 Mark II reactor operates with magnetic confinement to increase plasma density and hence to improve etch rate and uniformity. This type of reactor is often termed as magnetically enhanced reactive ion etcher (MERIE).

To facilitate selective anisotropic etching, inert gases such as argon are often used as the diluent with the above etchants. In the following examples unless stated otherwise, the reactor was powered at 13.56 MHz at 1000 W, or approximately 3 W/$cm^2$ power density. This resulted in a typical direct current (DC) bias voltage of about -900V. The chamber pressure was kept at 35 mTorr. The magnetic field was set at 50 Gauss.

Tables I shows the results from a series of experiments that measured dry etch rates for different first and second porous organosilicate materials at various Ar, $C_4F_6$, and $O_2$ flowrates. The dry etch rates are shown in the far right column. Comparison of Run 3a in Table 1 and Run 2 in Table 2 show that, at the same Ar, $C_4F_6$, and $O_2$ flowrates (146, 26, and 28 sccm, respectively), the dry etch rate for Example 4 and 5 compositions are only approximately 2.5 times that for Example 2 and 3 compositions.

Removal by Exposure to Various Stripper Formulations

Etch rates were determined in the following manner. A 200 ml volume of remover was placed in a 250 ml beaker with a 1" round stir bar to provide agitation (450 rpm). The beaker was placed on a hot plate to heat the test solution to the temperature specified in Table II, which was measured using a calibrated thermometer. A wafer segment at least 1" x 1" in size was used for each etch rate test. The segment was oven baked for 10 minutes at either 110°C or 200°C, then cooled in a nitrogen storage box for three minutes. The initial dielectric film thickness measurements were taken in three different locations on the segment, using a Sentech SE-800 spectroscopic ellipsometer, and recorded on the etch rate form. Forceps were used to place the segment into the test solution for five minutes. If only one segment was being tested, then a dummy segment of bare silicon was also placed in the beaker on the opposite side of the dielectric segment. The dielectric segment was removed from the test solution and placed in a beaker for a DI water overflow rinse. The segment was rinsed for three minutes, removed from the DI water, and dried by blowing $N_2$ onto the segment. The segment was baked as previously stated, and the dielectric film thickness was measured in three different locations on the segment and recorded on the etch rate form. After taking the thickness measurements, the process was performed was as follows: the segments were immersed in the wet etch remover; rinsed with deionized water; dried in a nitrogen atmosphere; baked; and measured for thickness. This process was continued at cumulative immersion times of 10, 20, 40, and 60 minutes. If the film was completely removed prior to reaching a cumulative strip time of 60 minutes, the test ended at that point.

The three measurements taken at each immersion time were averaged together. Thickness data was plotted against immersion time, and a linear regression trend line was fitted to the curve. The slope of the trend line is the etch rate (the slope is a negative value, but the etch rate is expressed as a positive number). In cases where the film was completely removed within the first five minutes, it could not determined if the film actually etched away, or if the film simply delaminated from the segment and no real etching took place. When this occurred, the etch rate was recorded as >A, where A is the ratio of the initial thickness divided by 5 minutes.

Table II provides the wet etch rate data for various etchant formulations. The column labeled "Wet Etch ratio" shows the ratio of wet etch rates for exemplary films 4 relative to that of exemplary films 3 for various etchants. The second column indicates the chemical type of the formulation. This table shows that the wet stripper formulation EZStrip™ 20 gives a wet etch rate of exemplary films 4 that is approximately 30 times that of the wet etch rate for exemplary film 3. EZStrip™ 20 is a semi-aqueous amine. Another semi-aqueous amine, 970, gives a wet etch ratio of approximately 8. A ratio of approximately six is obtained with NE-111, which is a fluorine-containing remover.

**Table I: Dry etch rates for various film materials**

| Film | Etch Rate (nmlmin) | Etch Time (seconds) | Ar Flow (sccm) | $C_4F_6$ Flow (sccm) | $O_2$ Flow (sccm) |
|---|---|---|---|---|---|
| Example 3a | 66 | 20 | 146 | 26 | 28 |
| Example 3b | 204 | 60 | 146 | 26 | 28 |
| Example 3c | 170 | 60 | 143 | 26 | 31 |
| Example 3d | 234 | 60 | 140 | 26 | 34 |

(continued)

| Film | Etch Rate (nmlmin) | Etch Time (seconds) | Ar Flow (sccm) | $C_4F_6$ Flow (sccm) | $O_2$ Flow (sccm) |
|---|---|---|---|---|---|
| Example 3e | 336 | 60 | 137 | 26 | 37 |
| Example 3f | 428 | 60 | 135 | 26 | 39 |
| Example 2a | 113 | 60 | 146 | 26 | 28 |
| Example 2b | 138 | 60 | 143 | 26 | 31 |
| Example 2c | 166 | 60 | 140 | 26 | 34 |
| Example 2d | 196 | 60 | 137 | 26 | 37 |
| Example 4a | 494 | 30 | 146 | 26 | 28 |
| Example 5a | 600 | 30 | 146 | 26 | 28 |
| Example 4b | 492 | 30 | 146 | 26 | 28 |
| Example 4c | 335 | 30 | 146 | 26 | 28 |

**Table II: Wet etch rates for various etchants**

| Wet Etch Removal Product(1) | Remover Type | Temp (°C) | Example 4 (Spin-On Film) [A] | Example 1 (PECVD Dense Film) | Example 3 (PECVD and UV Exposed Porous Film) [B] | Wet Etch ratio [A]/[B] |
|---|---|---|---|---|---|---|
| NE-89 | Fluoride-containing | 25 | >600 | 2 | 505 | ~1 |
| NE-111 | Fluoride-containing | 25 | >600 | <1 | 107 | ~6 |
| 970 | Semi-aqueous amine | 75 | 42 | <1 | 5 | ~8 |
| AS-65 | Semi-aqueous amine | 65 | 55 | <1 | 18 | ~3 |
| EZStrip ™ 20 | Semi-aqueous amine | 65 | 34 | 1 | 1 | ~30 |
| EZStrip™ 101 | Solvent-based | 65 | 1 | <1 | 1 | -1 |
| EZStrip™ 510 | Fluoride-containing | 25 | 1 | <1 | 1 | ~1 |
| EZStrip ™ 520 | Fluoride-containing | 25 | 2 | <1 | 1 | ~2 |
| EZStrip™ 521 | Fluoride-containing | 50 | >300 | 2 | >1000 | ~1 |
| EZStrip™ 522 | Fluoride-containing | 25 | >600 | <1 | 215 | ~3 |
| EZStrip™ 523 | Fluoride-containing | 55 | >600 | 1 | 540 | ~1 |

(continued)

| Wet Etch Removal Product(1) | Remover Type | Temp (°C) | Example 4 (Spin-On Film) [A] | Example 1 (PECVD Dense Film) | Example 3 (PECVD and UV Exposed Porous Film) [B] | Wet Etch ratio [A]/[B] |
|---|---|---|---|---|---|---|
| EZStrip™ 524 | Fluoride-containing | 40 | >300 | 1 | >500 | -1 |
| EZStrip™ 601 | Solvent-based | 65 | >600 | 2 | >1000 | ~1 |
| (1) - Wet Etch Removers are commercially available from Air Products and Chemicals, Inc. of Allentown, PA. | | | | | | |

Converting the Above Materials in Accordance for Use in the Present Invention

A light absorbing compound was added to the material of Example 5 to yield a porous sacrificial light absorbing material for 193 nm photolithographic processing. The selectivity for removal of the porous sacrificial light absorbing material relative that of the porous dielectric material during the wet etch process was substantially unchanged.

A light absorbing compound was added to the material of Example 4 to yield a porous sacrificial light absorbing material for 193 nm photolithographic processing. The selectivity for removal of the porous sacrificial light absorbing material relative that of the porous dielectric material during the dry and wet etch processes were adversely impacted. Improvements in wet etch selectivity can be obtained by changing the porosity of the sacrificial light absorbing material and altering the composition. Comparable dry etch rates for the porous sacrificial light absorbing material and the porous dielectric can be obtained by altering the composition and by changing the porosity of the sacrificial light absorbing material. Further optimization of wet and dry etch rates can be obtained by tailoring the wet and dry etch processes and chemistries through standard experimental design practices well known to those skilled in the art.

Although the foregoing description has specified certain steps, materials, and equipment that may be used in such a method for making a semiconductor device, those skilled in the art will appreciate that many modifications and substitutions may be made. For example, although the embodiments illustrated above apply the present invention to a method that forms the via prior to forming the trench, the process of the present invention is equally applicable to methods that form the trench prior to forming the via. Accordingly, it is intended that all modifications, alterations, substitutions and additions to the above described embodiments be considered to fall within the spirit and scope of the invention as defined by the appended claims.

## Claims

**1.** A method of forming a feature in a substrate comprising:

forming a porous dielectric layer on a substrate;
removing a first portion of the porous dielectric layer to form a first etched region;
filling the first etched region with a porous sacrificial light absorbing material having dry etch properties similar to those of the porous dielectric layer;
removing a portion of the porous sacrificial light absorbing material and a second portion of the porous dielectric layer to form a second etched region; and
removing the remaining portions of the porous sacrificial light absorbing material by employing a process, wherein the porous sacrificial light absorbing material has an etch rate greater than that of the porous dielectric layer in the process.

**2.** The method of claim 1 wherein the substrate is a semiconductor wafer.

**3.** The method of claim 1 further comprising the steps of:

depositing then patterning a layer of photoresist prior to the step of removing a first portion of the porous dielectric layer to form a first etched region; and
depositing then patterning a layer of photoresist, after the step of filling the first etched region with a porous

sacrificial light absorbing material having dry etch properties similar to those of the porous dielectric layer.

**4.** The method of claim 1 wherein the step of removing a first portion of the porous dielectric layer is performed by a dry etch process.

**5.** The method of claim 1 wherein the step of removing a portion of the porous sacrificial light absorbing material and a second portion of the porous dielectric layer is performed by a dry etch process.

**6.** The method of claim 1 wherein process employed for the step of removing the remaining portions of the porous sacrificial light absorbing material is a dry etch process.

**7.** The method of claim 1 wherein process employed for the step of removing the remaining portions of the porous sacrificial light absorbing material is a wet etch process.

**8.** The method of claim 1 wherein the porous dielectric layer comprises Si, C, O, and H.

**9.** The method of claim 8 wherein the porous dielectric layer further comprises N, F, B, Al, Ge, and P.

**10.** The method of claim 1 wherein the porous dielectric layer is formed by a chemical vapor deposition process.

**11.** The method of claim1 wherein the porous dielectric layer is formed by a non-contact induced deposition process.

**12.** The method of claim 1 wherein the porous sacrificial light absorbing material comprises Si, C, O, and H.

**13.** The method of claim 12 wherein the porous sacrificial light absorbing material further comprises S, Ti, V, N, F, B, Al, Ge, P, Zn, In, Sn, Ga, or mixtures thereof.

**14.** The method of claim 12 wherein the porous sacrificial light absorbing material is light absorbing at wavelengths of 248 nanometers or below or 193 nanometers or below.

**15.** The method of claim 14 wherein the porous sacrificial light absorbing material comprises one or more of additives selected from the group consisting of dyes, halogenated triazines, onium salts, sulfonated esters, diaryliodonium salts, triazines, iodonium salts, sulfonium salts, diazomethanes, halogenated sulfonyloxy dicarboximides, benzoin tosylate, t-butylphenyl alpha-(p-toluenesulfonyloxy)-acetate, t-butyl alpha-(p-toluenesulfonyloxy)acetate, N-Hydroxyphtalimide triflate, 2-(4-Methoxystyryl)-4,6-bis(trichloromethyl)-1,3,5-triazine, N-hydroxy-5-norbornene-2,3-dicarboximide nanoflate, 2-nitrobenzyl cyclohexanecarbamate, triphenylsulfonium hydroxide, isopropyl-9H-thioxanthen-9-one, anthracene carbonitrile, anthracene methanol, the disodium salt of anthroquinonoe disulfonic acid, pyrene, perylene, and mixtures thereof.

**16.** The method of claim1 wherein the step of filling the first etched region with a porous sacrificial light absorbing material is performed by a chemical vapor deposition process.

**17.** The method of claim1 wherein the step of filling the first etched region with a porous sacrificial light absorbing material is performed by a non-contact induced deposition process.

**18.** The method of claim 1 wherein the porous dielectric layer and the porous sacrificial light absorbing material comprise an organosilicate.

**19.** The method of claim 18 wherein the porous dielectric layer is an organosilicate material produced by a chemical vapor deposition process employing at least one silica precursor comprising diethoxymethylsilane.

**20.** The method of claim 18 wherein the porous sacrificial light absorbing material is formed by a spin-on deposition process, wherein the spin-on process employs a mixture comprising a silica source, a solvent, and a light absorbing material.

**21.** The method of claim 20 wherein the spin-on process employs a mixture further comprising a porogen.

**22.** The method of claim 18 wherein the porosity in the porous dielectric layer is a different structure than the porosity

of the porous sacrificial light absorbing material.

**23.** The method of claim 22 wherein the porous sacrificial light absorbing material has an interconnected pore structure.

**24.** A method of forming a feature in a substrate comprising:

forming a porous dielectric layer on a substrate by plasma enhanced chemical vapor deposition of at least one silica precursor gas comprising diethoxymethylsilane;
removing a first portion of the porous dielectric layer to form a first etched region by a dry etch process;
filling the first etched region with a porous sacrificial light absorbing material by depositing by a spin-on process a film-forming fluid comprising a functionalized alkoxysilane precursor, a catalyst, a porogen, a light absorbing material, and a solvent followed by removal of the solvent and the porogen, wherein the resulting material has dry etch properties similar to those of the porous dielectric layer;
removing a portion of the porous sacrificial light absorbing material and a second portion of the porous dielectric layer to form a second etched region; and
exposing the substrate to a wet etch solution to remove the remaining portions of the porous sacrificial light absorbing material, which has a wet etch rate greater than that of the porous dielectric layer.

**25.** A composition comprising a functionalized alkoxysilane, a porogen, a light absorbing material, and a solvent.

**26.** A porous sacrificial light absorbing material made from the composition of claim 25.

**27.** An article produced by the method of claim 1.

**28.** An article produced by the method of claim 25.

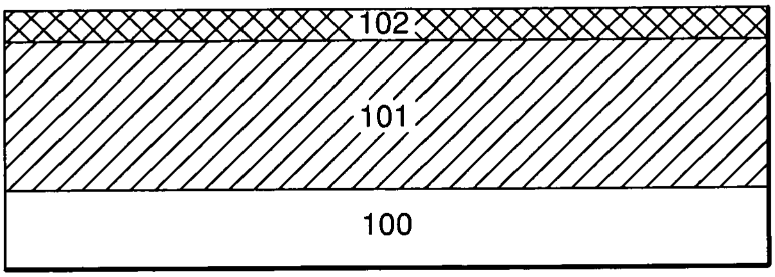


Figure 1A

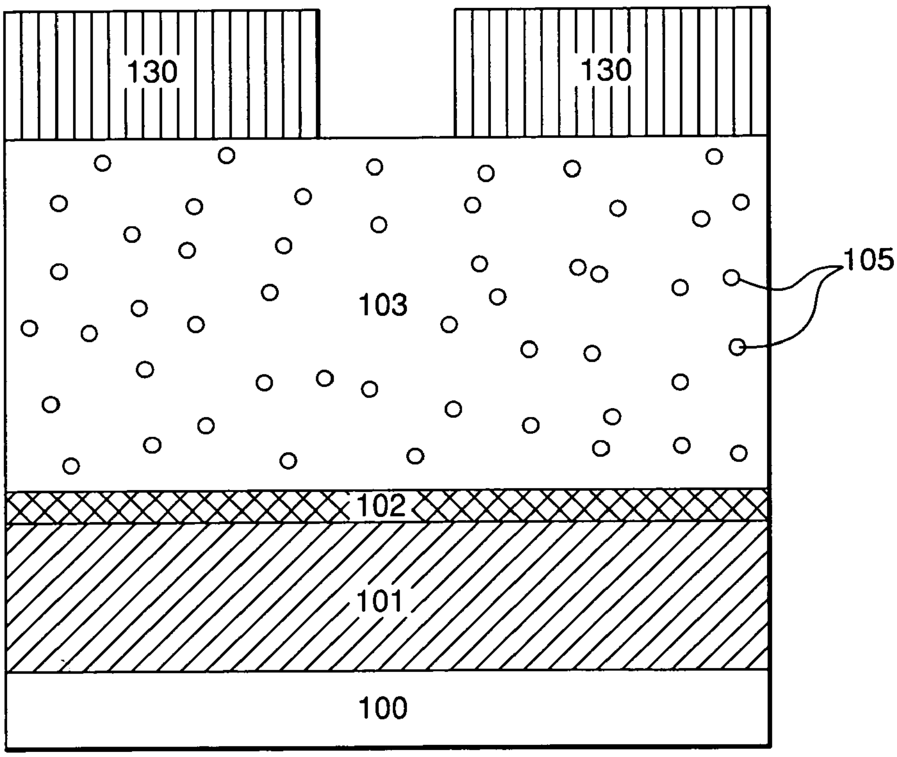


Figure 1B

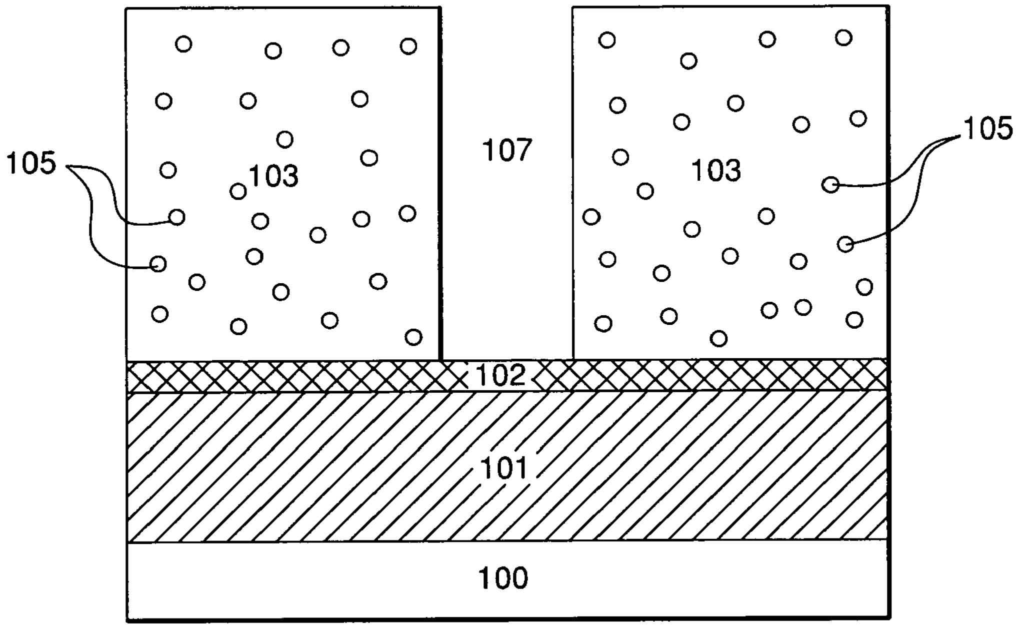


Figure 1C

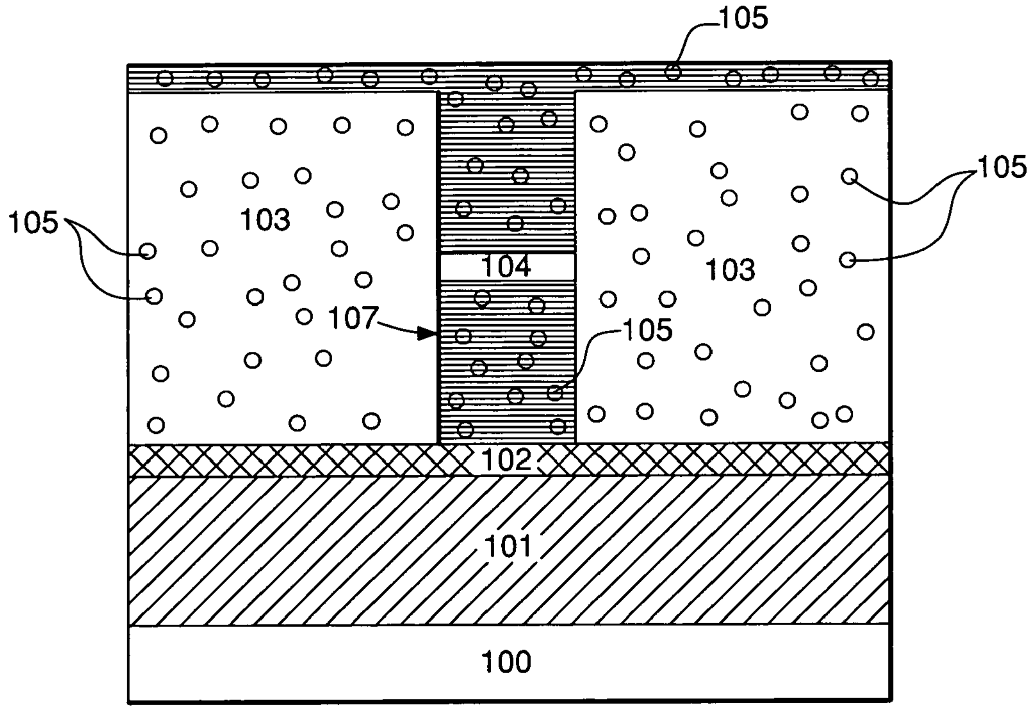


Figure 1D

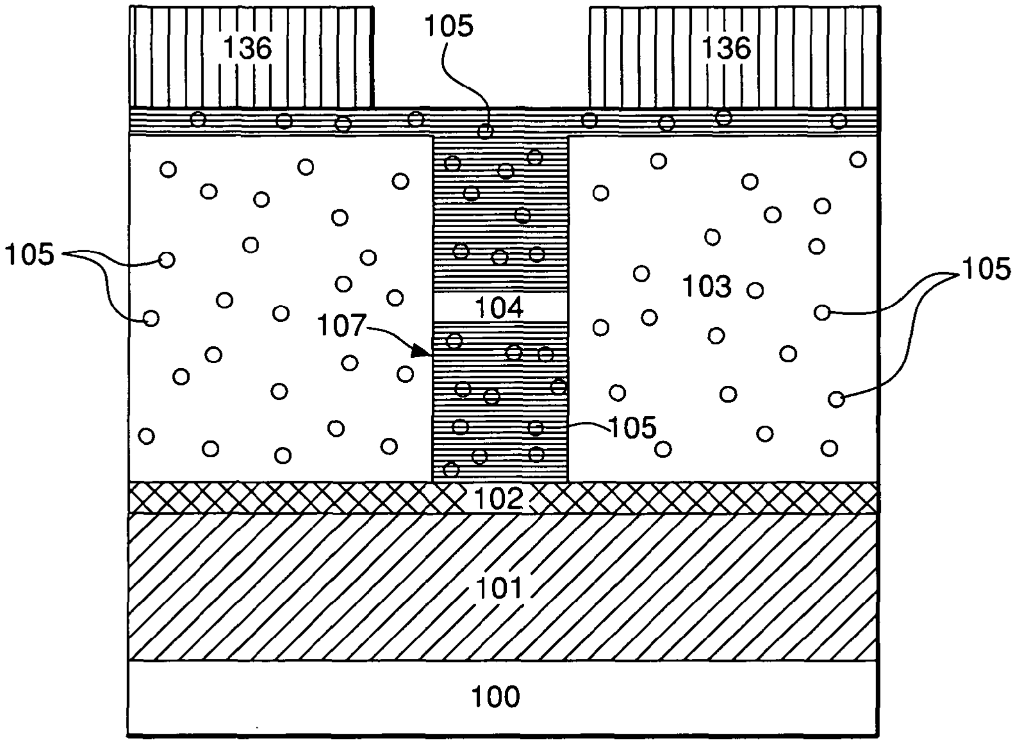


Figure 1E

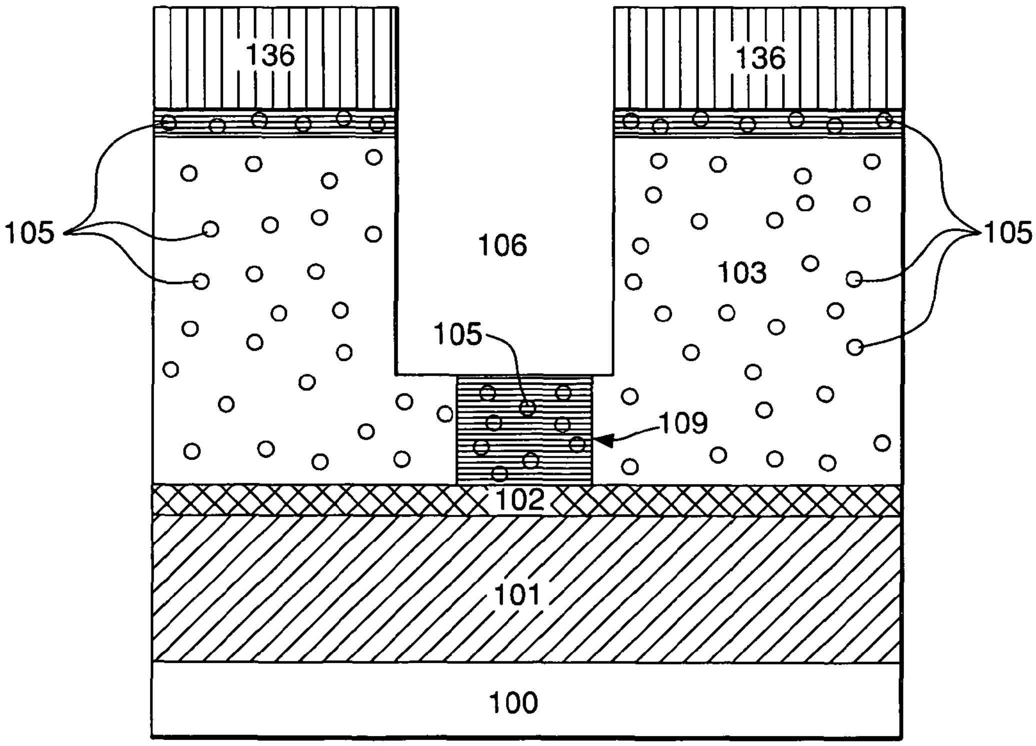


Figure 1F

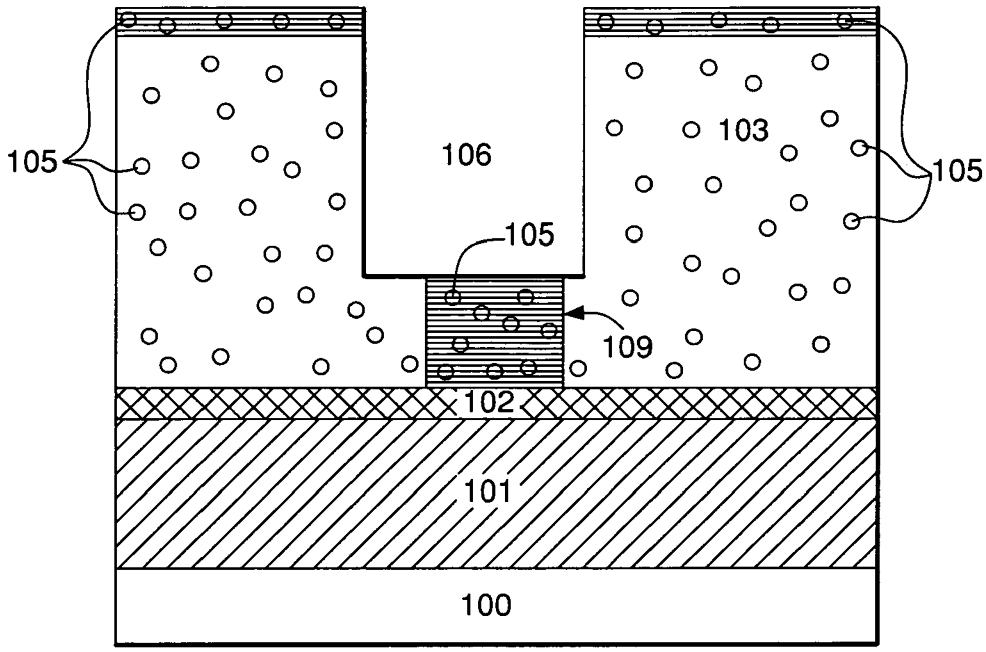


Figure 1G

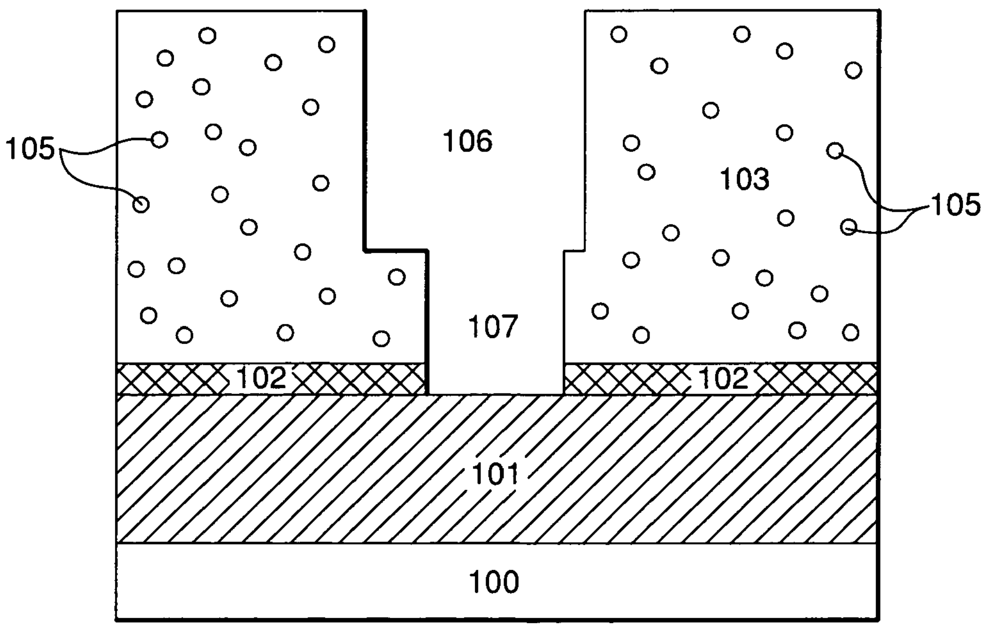


Figure 1H

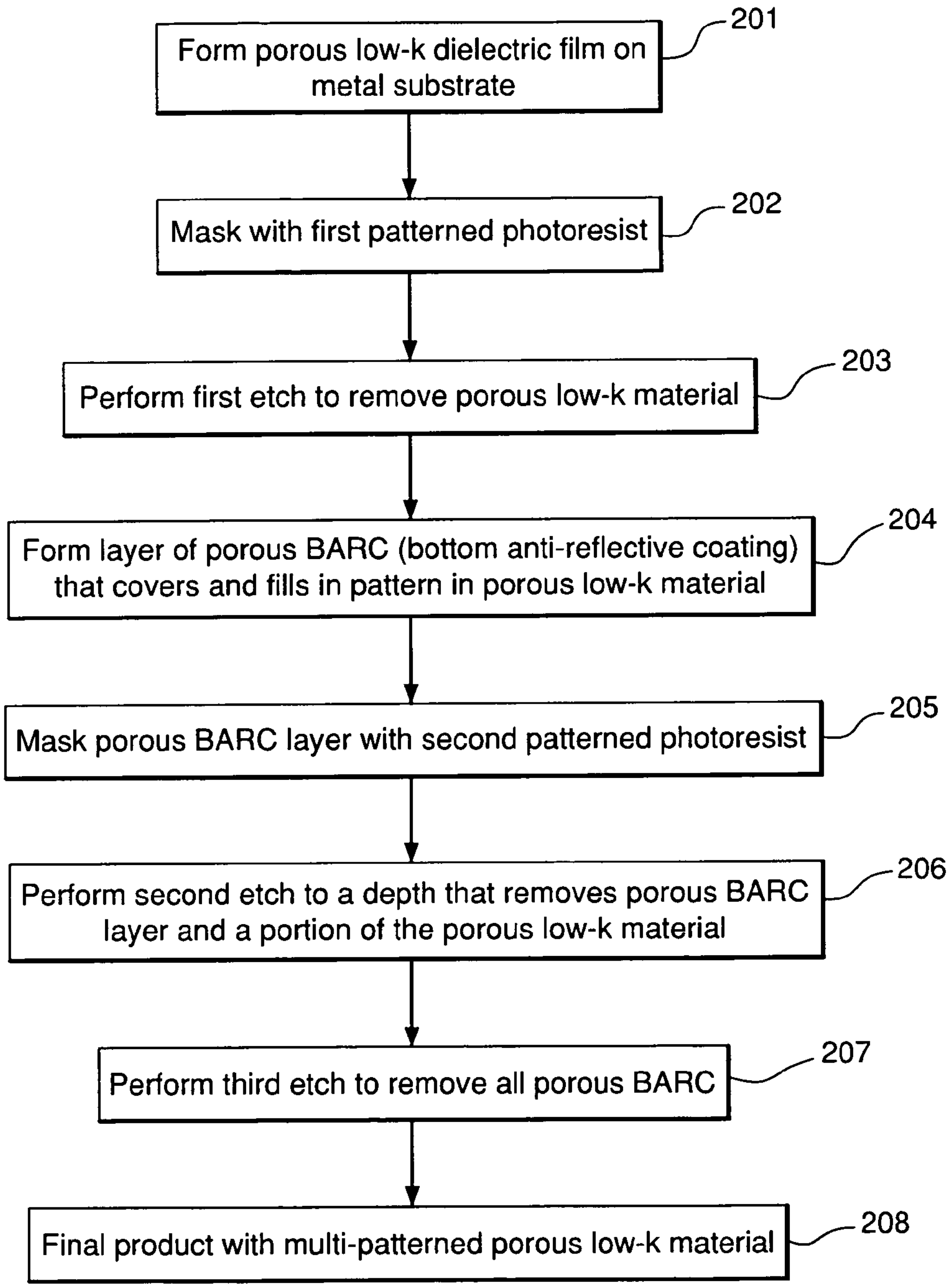
Form porous low-k dielectric film on metal substrate
201
Mask with first patterned photoresist
202
Perform first etch to remove porous low-k material
203
Form layer of porous BARC (bottom anti-reflective coating) that covers and fills in pattern in porous low-k material
204
Mask porous BARC layer with second patterned photoresist
205
Perform second etch to a depth that removes porous BARC layer and a portion of the porous low-k material
206
Perform third etch to remove all porous BARC
207
Final product with multi-patterned porous low-k material
208

Figure 2

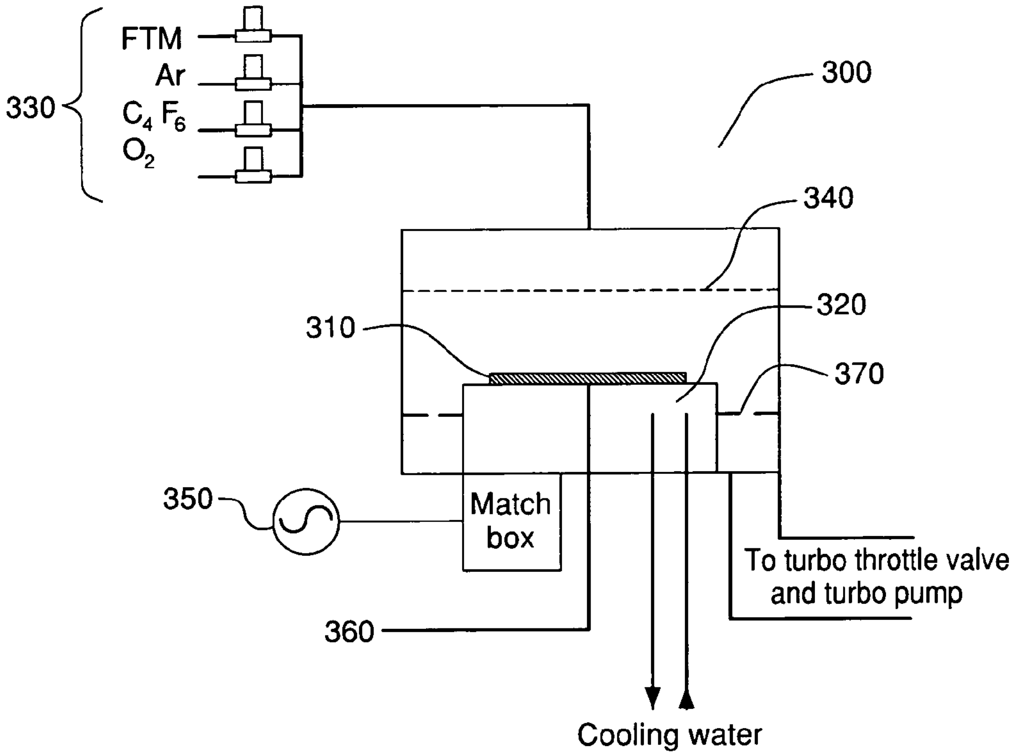
FTM
Ar
$C_4F_6$
$O_2$
330
300
340
320
310
370
350
Match box
360
To turbo throttle valve and turbo pump
Cooling water

Figure 3